Europäisches Patentamt

European Patent Office

Office européen des brevets

(19)

(11) Veröffentlichungsnummer: **0 141 149**
**B1**

(12) **EUROPÄISCHE PATENTSCHRIFT**

(45) Veröffentlichungstag der Patentschrift:
**11.05.88**

(51) Int. Cl.⁴: **G 01 N 24/02**, G 01 N 24/06,
**G 01 N 24/08**

(21) Anmeldenummer: **84110567.9**

(22) Anmeldetag: **05.09.84**

(54) **Magneteinrichtung einer Anlage der Kernspin-Tomographie mit einer Abschirmvorrichtung.**

(30) Priorität: **19.09.83 DE 3333755**

(43) Veröffentlichungstag der Anmeldung:
**15.05.85 Patentblatt 85/20**

(45) Bekanntmachung des Hinweises auf die Patenterteilung:
**11.05.88 Patentblatt 88/19**

(84) Benannte Vertragsstaaten:
**DE FR GB NL**

(56) Entgegenhaltungen:
**EP - A - 0 011 335**
**EP - A - 0 067 933**
**EP - A - 0 111 218**

**ELECTRO/78 CONFERENCE RECORD, 23.-25. Mai 1978,
Seiten 30/2: 1-15, Boston, US; CHING-MING LAI u.a.:
"Nuclear magnetic resonance zeugmatography for
medical imaging"
REVIEW OF SCIENTIFIC INSTRUMENTS, Band 52, Nr. 9,
September 1981, Seiten 1342-1351, New York, US; D.I.
HOUIT u.a.: "Electromagnet for nuclear magnetic
resonance imaging"**

(73) Patentinhaber: **Siemens Aktiengesellschaft Berlin und
München, Wittelsbacherplatz 2, D-8000 München 2 (DE)**

(72) Erfinder: **Ries, Günter, Dr., Schobertweg 2,
D-8520 Erlangen (DE)**
Erfinder: **Siebold, Horst, Dr., Starenweg 3,
D-8520 Erlangen (DE)**

## Beschreibung

Die Erfindung bezieht sich auf eine Magneteinrichtung einer Anlage der Kernspin-Tomographie mit mehreren Magnetspulen, welche einen zur Aufnahme eines zu untersuchenden Körpers geeigneten Innenraum umschließen und in diesem ein zumindest weitgehend homogenes Magnetfeld erzeugen, und mit einer die Spulen umgebenden, zylinderförmigen, aus ferromagnetischem Material betehenden Abschirmvorrichtung, die ein zumindest weitgehend zylindermantelförmiges Bauteil und an dessen stirnseitigen Enden je ein scheibenförmiges Bauteil mit einer zentralen Öffnung mit vorbestimmtem Radius bezüglich der Zylinderachse aufweist. Eine derartige Magneteinrichtung ist aus der EP-A-67 933 bekannt.

Auf dem Gebiet der medizinischen Diagnostik sind bildgebende Verfahren entwickelt worden, bei denen durch rechnerische oder meßtechnische Analyse integraler Resonanzsignale von Kernen wie z.B. Protonen aus der räumlichen Spindichte- und/oder Relaxationszeitverteilung eines zu untersuchenden Körpers ein Bild ähnlich einem Röntgentomogramm konstruiert wird. Das entsprechende Verfahren wird auch als Zeugmatographie bezeichnet («Nature», Vol. 242, 1973, Seiten 190 und 191).

Da bekanntlich das Kernresonanzsignal mit wachsendem magnetischen Grundfeld zunimmt, wird für Anlagen der Kernspin-Tomographie (Nuclear-Magnetic-Resonance-Anlagen) ein möglichst starkes Grundfeld angestrebt, das in einem Meßbereich eine ausreichende Homogenität aufweist. Dieses Grundfeld ist von stationären und/oder gepulsten Gradientenfeldern überlagert. Außerdem muß ein senkrecht zu dem Grundfeld orientiertes Hochfrequenzfeld vorgesehen werden. Die Abmessungen der entsprechenden, eine Magnetspulenanordnung bildenden Spulen sind dabei den Dimensionen des zu untersuchenden Körpers so anzupassen, daß dieser in den Meßbereich innerhalb eines von den Spulen umgebenen Innenraumes ohne weiteres eingeschoben werden kann.

Das starke Magnetfeld einer derartigen Magnetspulenanordnung soll sich jedoch im wesentlichen nur in dem Meßbereich befinden, sich aber möglichst nicht in Form eines Streufeldes in die Umgebung der Anordnung ausbreiten, wo es z.B. zu Störungen in bestimmten elektronischen Geräten führen oder auch eine unerwünschte Kraftwirkung auf ferromagnetische, bewegliche Teile ausüben kann. Es sind deshalb besondere Abschirmvorrichtungen erforderlich, um das Streufeld außerhalb der Magnetspulenanordnung zu verringern.

Eine entsprechende Abschirmvorrichtung geht z.B. aus der eingangs genannten EP-A-67 933 hervor. Diese Vorrichtung, welche eine Magnetspulenanordnung mit einer zylinderförmigen, normalleitenden Feldspule umschließt, enthält einen die Spule umgebenden, geschlossenen Zylindermantel aus Eisen. An den Stirnseiten dieses Zylindermantels sind Ringscheiben aus Eisen mit kreisförmigen zentralen Öffnungen angebracht, deren Durchmesser im wesentlichen durch die Abmessungen des zu untersuchenden Körpers und die geforderte Homogenität des Magnetfeldes bestimmt ist. Darüber hinaus ist an der Innenseite dieser so ausgebildeten Abschirmvorrichtung die Magnetspulenanordnung starr befestigt.

Da die bekannte Abschirmvorrichtung einen geschlossenen Zylindermantel aufweist, läßt sie sich nur für normalleitende, nicht aber für supraleitende Magnete verwenden. Bei solchen supraleitenden Magneten sind nämlich seitliche Öffnungen wie z.B. für den sogenannten Turm des erforderlichen Kryostaten sowie für Pumpstutzen erforderlich. Außerdem ist bei dieser Vorrichtung keine Möglichkeit einer Justierung der Magnetspulen zur Korrektur von Gradientenfehlern gegeben.

Aufgabe der vorliegenden Erfindung ist es deshalb, die eingangs genannte Magneteinrichtung mit einer Abschirmvorrichtung dahingehend zu verbessern, daß die erwähnten Schwierigkeiten zumindest weitgehend behoben sind, wobei im Meßbereich eine ausreichend hohe Feldhomogenität erhalten bleiben soll.

Diese Aufgabe wird erfindungsgemäß dadurch gelöst, daß als annähernd zylindermantelförmiges Bauteil der Abschirmvorrichtung mindestens vier baugleiche, in Umfangsrichtung auf der Zylindermantelfläche regelmäßig verteilt angeordnete balkenartige Abschirmelemente vorgesehen sind, wobei zwischen benachbarten Abschirmelementen jeweils ein Zwischenraum ausgebildet ist.

Der Erfindung liegt nämlich die Erkenntnis zugrunde, daß es für eine effektive Verringerung des Streufeldes außerhalb der Magnetspulenanordnung ausreicht, den Querschnitt an ferromagnetischem Material des bekannten zylinderförmigen Bauteiles auf mindestens vier einzelne balkenartige Abschirmelemente zu konzentrieren. Aufgrund der so zwischen benachbarten Abschirmelementen ausgebildeten Zwischenräume ist ein guter seitlicher Zugang zu der Magnetspulenanordnung und ausreichend Raum für seitlich herausragende Kryostatenteile gegeben. In dem so erhaltenen starren Gerüst aus den balkenartigen Abschirmelementen und den stirnseitigen scheibenförmigen Bauteilen läßt sich die Magnetspulenanordnung justierbar aufhängen bzw. anordnen, wobei die Justierung auf verhältnismäßig einfache Weise vorgenommen werden kann.

In der nichtvorveröffentlichten, zum Stand der Technik nach Artikel 54(3)EPÜ gehörenden EP-A-O 111 218 ist zwar ein zylindermantelförmiges Bauteil einer Abschirmvorrichtung beschrieben, das durch eine Vielzahl axial verlaufender Stäbe aufgebaut sein kann, um so in Umfangsrichtung verlaufende Wirbelströme zu unterbinden. Diese Stäbe sind jedoch so eng aneinandergefügt, daß im Gegensatz zum Erfindungsgegenstand ein quasi-geschlossener Zylindermantel erhalten wird. Damit sind auch bei diesem Stand der Technik die im Zusammenhang mit der EP-A-O 067 933 erläuterten Probleme gegeben. Insbesondere fehlt in der EP-A-O 111 218 jeder Hinweis auf die vorstehend erwähnte Erkenntnis, daß es im Hinblick auf die für die Kernspintomographie zu fordernden Homogenitätsverhältnisse möglich ist, den beschriebenen geschlossenen oder quasi-geschlossenen Abschirmzylinder in einzelne balkenförmige Abschirmelemente aufzulösen.

Vorteilhafte Ausgestaltungen der Magneteinrichtung nach der Erfindung gehen aus den Unteransprüchen hervor.

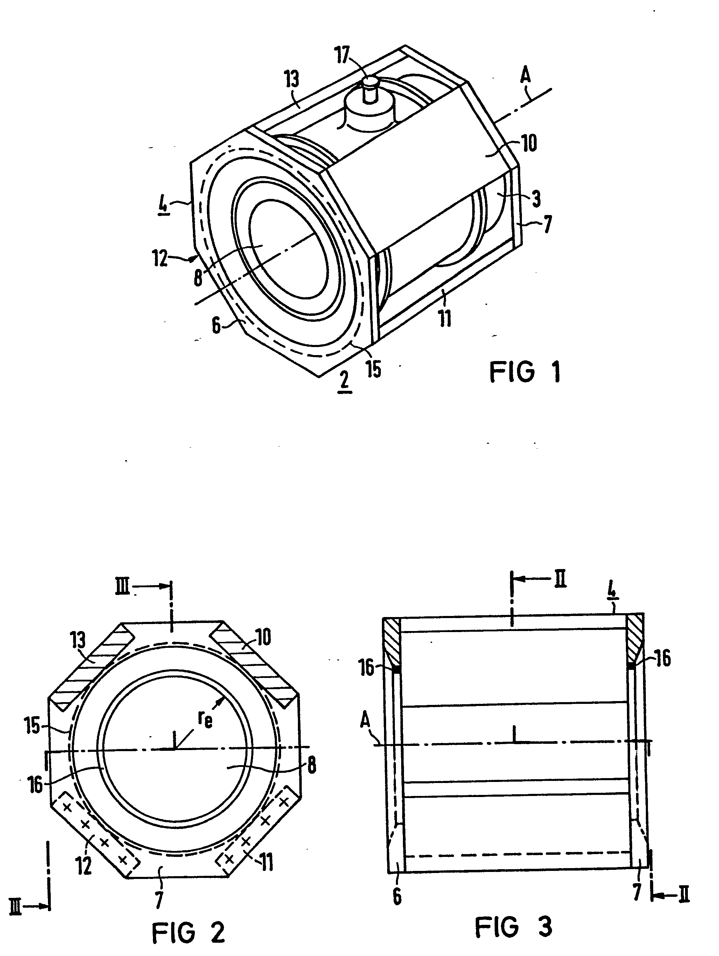

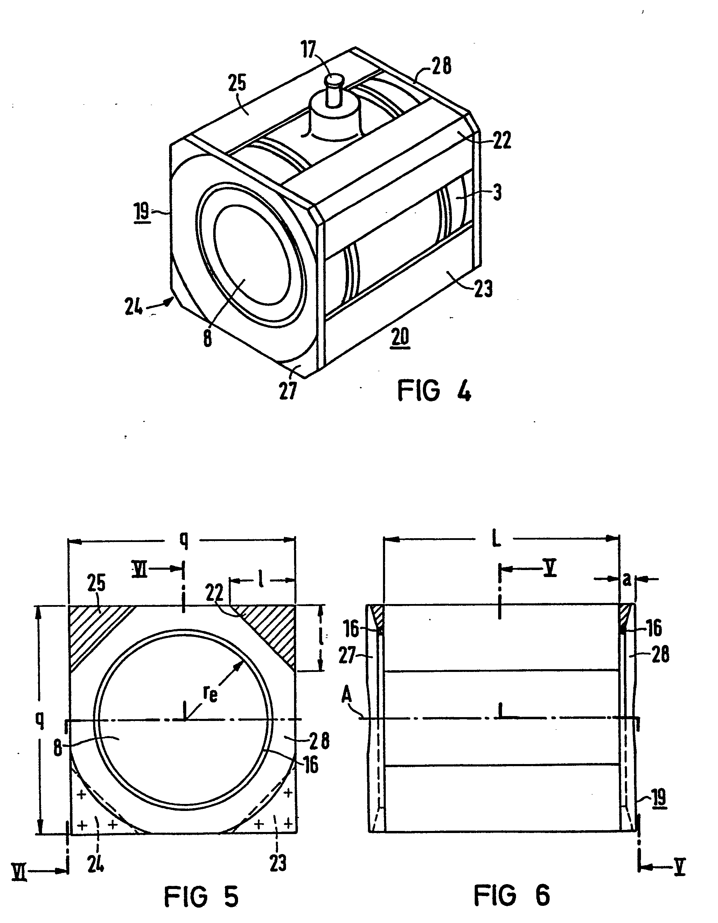

Zur weiteren Erläuterung der Erfindung wird auf die Zeichnung Bezug genommen, in deren Figuren 1 bis 3 eine Magneteinrichtung nach der Erfindung mit einer Abschirmvorrichtung schematisch in Schrägansicht bzw. als teilweiser Querschnitt bzw. als Längsschnitt dargestellt ist. Figuren 4 bis 6 zeigen in entsprechender Darstellung eine weitere Ausführungsform einer Abschirmvorrichtung.

Bei Kernspin-Tomographie-Anlagen, für welche die Magneteinrichtung nach der Erfindung vorzusehen ist, wird von bekannten Kernspin-Tomographie-Apparaturen ausgegangen (vergleiche z.B. EP-A-21 535 oder DE-A-29 21 252). Eine derartige Apparatur weist im allgemeinen eine Magneteinrichtung mit einer Anordnung von normal- oder supraleitenden Feldspulen auf, mit denen ein starkes, möglichst homogenes Grundfeld in einem zentralen Meßbereich hervorzurufen ist.

Ein Ausführungsbeispiel einer entsprechenden Magneteinrichtung nach der Erfindung ist in den Figuren 1 bis 3 angedeutet. Dabei ist in den Figuren 2 und 3 lediglich die Abschirmvorrichtung dieser Magneteinrichtung wiedergegeben. Diese allgemein mit 2 bezeichnete Einrichtung weist vorzugsweise eine supraleitende Magnetspulenanordnung auf, die sich innerhalb eines Kryostaten 3 befinden soll. Die Magnetspulenanordnung und der Kryostat 3 erlauben einen axialen Zugang zu einem homogenen Feldbereich in ihrem Zentrum, d.h. der zu untersuchende Körper wid längs einer Achse A in das Magnetfeld eingebracht.

In dem Zentrum des homogenen Feldbereiches wird eine magnetische Flußdichte von 0,1 bis 2 Tesla angestrebt. Die Magnetspulen rufen somit ein erhebliches Streufeld außerhalb der Anordnung hervor, falls nicht besondere Maßnahmen zur Streufeldverringerung vorgesehen werden. Das Streufeld verhältnismäßig kurzer Magnete nimmt mit einem $r^{-3}$-Gesetz ab, wenn es sich in Luft ungestört ausbreiten kann. Dabei verbinden die Flußlinien auf langen Wegen durch den Außenraum die Austrittsstellen aus den beiden Polen der Magnete. Diese Flußlinien können nun durch Einleiten in besondere ferromagnetische Strukturen aufgefangen werden, wo sie sich auf etwa 1 bis 1,5 Tesla Flußdichte konzentrieren, so daß außerhalb dieser Strukturen das Streufeld deutlich abgesenkt ist.

Dementsprechend ist die erfindungsgemäße Magneteinrichtung mit einer besonderen Abschirmvorrichtung 4 aus ferromagnetischem Material versehen. Die Feldformung geschieht dabei im wesentlichen durch die Kontur des ferromagnetischen Materials an Ein- und Austrittsstellen von magnetischem Fluß, also hauptsächlich durch die Form der Enden der Flußrückführung. Um hier der idealen zylindersymmetrischen Form nahezukommen, sind an den Stirnseiten der supraleitenden Magnetspulenanordnung bzw. des sie umgebenden Kryostaten 3 als Endpole massive Platten 6 und 7 mit jeweils einer runden zentralen Bohrung 8 vorgesehen, in welche in Längsrichtung, d.h. parallel zu der Achse A verlaufende balkenförmige Abschirmelemente 10 bis 13 münden. Diese Elemente haben gleichmäßige Gestalt und liegen untereinander regelmäßig verteilt auf einer gedachten Zylindermantelfläche, die durch eine gestrichelte Linie 15 angedeutet und konzentrisch um die Achse A angeordnet ist.

Der Radius $r_e$ der zentralen Bohrung 8 in den als gleichseitiges 8-Eck gestalteten Endplatten 6 und 7 ist so gewählt, daß einerseits ein ausreichender Zugang in das Innere der Magneteinrichtung gestattet und andererseits der Feldfehler im Nutzvolumen um das Spulenzentrum minimal wird. Er läßt sich durch Versuche verhältnismäßig einfach festlegen. Zur Feinkorrektur des Magnetfeldes kann dieser Radius auch noch mit eingelegten Ringen oder Blechen aus ferromagnetischem Material, sogenannten Shimringen 16 verkleinert werden.

Die balkenförmigen Abschirmelemente 10 bis 13 und die Endplatten 6 und 7 bilden ein starres, selbsttragendes Gerüst, in dem vorteilhaft die Magnetspulenanordnung an in den Figuren nicht ausgeführten Justierelementen verstellbar aufgehängt ist. Daneben ist es auch möglich, die Magnetspulen auf einem eigenen Grundgestell justierbar anzuordnen. Mit den drei Translations- und zwei Kippfreiheitsgraden können dann durch die Justierung der Spulenanordnung bzw. ihrer Spulen gegen das Gerüst fünf Feldfehlertherme (X-Y-Z-Gradient, zwei Fehler zweiten Grades) eliminiert werden.

Da es für die Zwecke der Kernspin-Tomographie ausreichend ist, den für die Flußrückführung nötigen Querschnitt an ferromagnetischem Material, von z.B. 0,8 m² bei einer 1 Tesla-Magnetspulenanordnung auf vier symmetrisch angeordnete balkenförmige Abschirmelemente zu verteilen, ergibt sich zwischen den Balken 10 bis 13 vorteilhaft ein verhältnismäßig großer Zwischenraum, der für einen Turm 17 des Kryostaten 3 zur Verfügung steht. Da ferner der nötige Eisenquerschnitt der Balken in breiten, radial weniger auftragenden Elementen untergebracht werden kann, läßt sich der Abstand zwischen der Magnetachse A und dem die Magneteinrichtung 2 tragenden Boden entsprechend kleiner halten. Außerdem ist eine verhältnismäßig einfache Fertigung, Montage und Justage ermöglicht.

Die balkenförmigen Abschirmelemente können eine beliebige Querschnittsform haben, z.B. gemäß den Figuren 1 bis 3 rechteckig sein. Vorzugsweise haben jedoch die vier balkenförmigen Abschirmelemente zumindest annähernd die Querschnittform rechtwinkeliger Dreiecke. Ein Ausführungsbeispiel einer entsprechenden Abschirmvorrichtung für eine Magneteinrichtung nach der Erfindung geht aus den Figuren 4 bis 6 hervor, wobei entsprechend den Figuren 1 bis 3 in Fig. 4 eine Schrägansicht, in Fig. 5 ein teilweiser Querschnitt und in Fig. 6 ein Längsschnitt wiedergegeben sind. Mit den Figuren 1 bis 3 übereinstimmende Teile sind dabei mit den gleichen Bezugszeichen versehen.

Die in den Figuren 4 bis 6 gezeigte Abschirmvorrichtung 19 einer Magneteinrichtung 20 enthält somit vier balkenförmige Abschirmelemente 22 bis 25 mit etwa dreieckigem Querschnitt. Zusammen mit etwa quadratischen Endplatten 27 und 28 können sie zu einer Rückführung montiert werden, deren Querabmessungen im Falle einer 1 Tesla-Magnetspulenanordnung kaum größer als der Außendurchmesser der Magnetspulenanordnung bzw. des Kryostaten 3 ist.

Abweichend von den in den Figuren wiedergegebenen Darstellungen der balkenförmigen Abschirmelemente 10 bis 13 bzw. 22 bis 25 kann zur Verringerung der Einzelstückgewichte jeder Längsbalken auch aus mehreren parallelen Einzelbalken zusammengesetzt werden. Insbesondere kann dabei die Dreiecksbalkenform durch eine Anzahl kleinerer Rechteckquerschnitte angenähert werden.

Als konkretes Ausführungsbeispiel kann die in den Figuren 4 bis 6 gezeigte Abschirmvorrichtung 19 für einen bekannten supraleitenden 1 Tesla-Magneten vorgesehen sein, dessen Vakuumtank seines Kryostaten 3 einen maximalen Flanschdurchmesser von 210 cm und eine maximale axiale Länge von 225 cm hat. Zwischen dem Eisen der Abschirmvorrichtung 19 und dem Kryostaten 3 bleibt allseitig 30 mm freier Raum, insbesondere zur Justage. Die beiden Endplatten 27 und 28 haben deshalb Querabmessungen q von etwa 220 cm, und die axiale Länge L der vier Dreiecksbalken 22 bis 25 beträgt etwa 230 cm. Der für 1 Tesla benötigte Eisenquerschnitt von 0,84 m² ist auf die vier Dreiecksbalken 22 bis 25 gleichmäßig aufgeteilt. Die beiden Schenkel des Dreiecksquerschnittes jedes Balkens 22 bis 25 haben dabei jeweils eine Länge 1 von 65 cm. Die beiden Endplatten 27 und 28 mit einer maximalen axialen Ausdehnung a von 15 cm sind jeweils mit einer zentralen Öffnung 8 versehen, deren Radius etwa 85 cm groß ist. Zur Feinjustierung sind noch Shimringe 16 vorgesehen, die diesen Radius auf den Radius $r_e$ von etwa 82 cm verkleinern. Die Teile der Abschirmvorrichtung 19 können aus Gußstahl oder verhältnismäßig einfachen Eisensorten erstellt werden, da höherwertige Eisensorten wie z.B. Trafobleche praktisch weder bei der Feldgüte noch beim Streufeld Verbesserungen bringen. Der Abschirmfaktor (Feld ohne Eisen/Feld mit Eisen) dieser Abschirmvorrichtung beträgt 4 bis 5.

**Patentansprüche**

1. Magneteinrichtung (2) einer Anlage der Kernspin-Tomographie mit mehreren Magnetspulen, welche einen zur Aufnahme eines zu untersuchenden Körpers geeigneten Innenraum umschließen und in diesem ein zumindest weitgehend homogenes Magnetfeld erzeugen, und mit einer die Spulen umgebenden, zylinderförmigen, aus ferromagnetischem Material bestehenden Abschirmvorrichtung (4, 19), die ein zumindest weitgehend zylindermantelförmiges Bauteil und an dessen stirnseitigen Enden je ein scheibenförmiges Bauteil (6, 7; 27, 28) mit einer zentralen Öffnung (8) mit vorbestimmtem Radius ($r_e$) bezüglich der Zylinderachse (A) aufweist, dadurch gekennzeichnet, daß als annähernd zylindermantelförmiges Bauteil der Abschirmvorrichtung (4; 19) mindestens vier baugleiche, in Umfangsrichtung auf der gemeinsamen Zylindermantelfläche (15) regelmäßig verteilt angeordnete balkenartige Abschirmelemente (10 bis 13; 22 bis 25) vorgesehen sind, wobei zwischen benachbarten Abschirmelementen (10 bis 13; 22 bis 25) jeweils ein Zwischenraum ausgebildet ist.

2. Magneteinrichtung nach Anspruch 1, dadurch gekennzeichnet, daß die balkenförmigen Abschirmelemente (10 bis 13) rechteckige Querschnittsform aufweisen.

3. Magneteinrichtung nach Anspruch 1, dadurch gekennzeichnet, daß die balkenförmigen Abschirmelemente (22 bis 25) dreiecksförmige Querschnitte aufweisen.

4. Magneteinrichtung nach einem der Ansprüche 1 bis 3, dadurch gekennzeichnet, daß die scheibenförmigen Bauteile (6, 7; 27, 28) der Abschirmvorrichtung (4; 19) zentrale Öffnungen (8) haben, deren Radius ($r_e$) durch eingelegte Ringe (16) auf einen vorbestimmten Wert verkleinert ist.

5. Magneteinrichtung nach einem der Ansprüche 1 bis 4, gekennzeichnet durch supraleitende Magnetspulen innerhalb eines Kryostaten (3), der von der Abschirmvorrichtung (4, 19) umgeben ist.

6. Magneteinrichtung nach einem der Ansprüche 1 bis 5, dadurch gekennzeichnet, daß die Abschirmvorrichtung (4, 19) zugleich als mechanische Halterung für die Magnetspulen dient.

**Claims**

1. A magnetic arrangement (2) for a nuclear spin resonance tomography installation, comprising a plurality of magnetic coils which enclose an inner space suitable for accommodating a body which is to be examined, generating in the same space an at least sustantially homogeneous magnetic field, and with a cylindrical screening device (4, 19) consisting of ferromagnetic material and having an at least substantially cylindrical jacket-like component engaged around the coils, at the end faces of which there are respective disc-shaped components (6, 7; 27, 28) having a central aperture (8) of predetermined radius ($r_e$) relative to the cylinder axis (A), characterised in that, as an approximately cylindrical jacket-shaped component of the screening device (4, 19), there are provided at least four identically constructed bar-like screening elements (10 to 13; 22 to 25) regularly distributed over the common surface (15) of the cylindrical jacket in a peripheral direction, an intermediate space being formed in each case between adjacent screening elements (10 to 13; 22 to 25).

2. A magnetic arrangement according to Claim 1, characterised in that the bar-shaped screening elements (10 to 13) are of rectangular cross-section.

3. A magnetic arrangement according to Claim 1, characterised in that the bar-shaped screening elements (22 to 25) are of triangular cross-section.

4. A magnetic arrangement according to one of Claims 1 to 3, characterised in that the disc-shaped components (6, 7; 27, 28) of the screening device (4, 19) have central apertures (8) of which the radius ($r_e$) is reduced to a predetermined value by inserted rings (16).

5. A magnetic arrangement according to one of Claims 1 to 4, characterised by superconductive magnetic coils within a cryostat (3) which is enclosed by the screening device, (4, 19).

6. A magnetic arrangement according to one of Claims 1 to 5, characterised in that the screening device (4, 19) serves at the same time as a mechanical support for the magnetic coils.

## Revendications

1. Dispositif magnétique (2) d'une installation de tomographie à résonance magnétique nucléaire comportant plusieurs bobines magnétiques, qui entourent un espace intérieur convenant pour loger un corps à examiner et produisent, dans cet espace, un champ magnétique au moins dans une large mesure homogène, et un dispositif de blindage (4, 19) en forme de cylindre entourant les bobines, réalisé en un matériau ferromagnétique et qui comporte un composant au moins dans une large mesure en forme d'enveloppe cylindrique et, sur les extrémités frontales de ce composant, des composants respectifs en forme de disques (6, 7; 27, 28) munis d'une ouverture centrale (8) possédant un rayon prédéterminé ($r_e$) par rapport à l'axe (E) du cylindre, caractérisé par le fait qu'il est prévu, comme composant approximativement en forme d'enveloppe cylindrique du dispositif de blindage (4; 19), au moins quatre éléments de blindage (10 à 13; 22 à 25) en forme de poutres, de constitution identique répartis de façon régulière dans la direction circonférentielle sur la surface commune (15) de l'enveloppe cylindrique, des espaces intercalaires étant ménagés entre des éléments de blindage (10 à 13; 22 à 25) voisins.

2. Dispositif magnétique suivant la revendication 1, caractérisé par le fait que les éléments de blindage (10 à 13) en forme de poutres possèdent une section transversale de forme rectangulaire.

3. Dispositif magnétique suivant la revendication 1, caractérisé par le fait que les éléments de blindage (22 à 25) en forme de poutres possèdent des sections transversales triangulaires.

4. Dispositif magnétique suivant l'une des revendications 1 à 3, caractérisé par le fait que les composants en forme de disques (6, 7; 27, 28) du dispositif de blindage (4; 19) possèdent des ouvertures centrales (8), dont le rayon ($r_e$) est réduit à une valeur prédéterminée, par des bagues (16) insérées.

5. Dispositif magnétique suivant l'une des revendications 1 à 4, caractérisé par des bobines magnétiques supraconductrices situées à l'intérieur d'un cryostat (3), qui est entouré par le dispositif de blindage (4, 19).

6. Dispositif magnétique suivant l'une des revendications 1 à 5, caractérisé par le fait que le dispositif de blindage (4, 19) sert simultanément de support mécanique pour les bobines magnétiques.

FIG 1

FIG 2

FIG 3

FIG 4

FIG 5

FIG 6